Europäisches Patentamt

European Patent Office

Office européen des brevets

(11) Veröffentlichungsnummer: **0 474 710 B1**

(12) **EUROPÄISCHE PATENTSCHRIFT**

(45) Veröffentlichungstag der Patentschrift: **13.04.94**

(51) Int. Cl.5: **H04L 23/02**, H04L 25/48, H03M 5/14

(21) Anmeldenummer: **90908468.3**

(22) Anmeldetag: **04.06.90**

(86) Internationale Anmeldenummer:
**PCT/DE90/00433**

(87) Internationale Veröffentlichungsnummer:
**WO 90/15494 (13.12.90 90/28)**

(54) **VERFAHREN ZUR ANALOGEN ÜBERTRAGUNG BZW. SPEICHERUNG EINER DIGITALEN INFORMATION.**

(30) Priorität: **03.06.89 DE 3918551**

(43) Veröffentlichungstag der Anmeldung:
**18.03.92 Patentblatt 92/12**

(45) Bekanntmachung des Hinweises auf die Patenterteilung:
**13.04.94 Patentblatt 94/15**

(84) Benannte Vertragsstaaten:
**DE DK FR GB IT NL SE**

(56) Entgegenhaltungen:
**DE-B- 1 295 594          FR-A- 2 527 819
GB-A- 1 076 557          US-A- 3 377 625
US-A- 3 659 207          US-A- 3 697 697
US-A- 3 795 864**

**IBM Technical Disclosure Bulletin, vol. 14, no. 2, July 1971, New York, US, pages 642-643; L. Audretsch et al.: "Communication by smooth high-order composites of trigonometric product function"**

(73) Patentinhaber: **H. u. C. Elektronik GmbH
Gustav-Meyer-Allee 25
D-13355 Berlin(DE)**

(72) Erfinder: **HANSEN, Jens
Holländer Strasse 37
D-1000 Berlin 51(DE)**

(74) Vertreter: **Christiansen, Henning, Dipl.-Ing.
Patentanwalt
Pacelliallee 43/45
D-14195 Berlin (DE)**

## Beschreibung

Die Erfindung betrifft ein Verfahren der im Oberbegriff des Anspruchs 1 angegebenen Art sowie eine Schaltung nach dem Oberbegriff des Anspruchs 18.

Auf der Übertragungsstrecke unterliegt jedes Signal zahlreichen Störeinflüssen, die zu einer Verformung des ursprünglich sauber auf der Senderseite erzeugten Basissignals führen. Störquellen liegen dabei zum Teil im System selbst, wie etwa die Begrenzung des Übertragungsbandes, nichtlineare Phasenverläufe der Selektionsfilter und nichtlineare Demodulatorkennlinien; zum größten Teil jedoch beruhen diese Störungen auf äußeren Einflüssen, wie etwa Fremdeinstrahlungen bei häufig zu geringem Empfangssignalpegel. Hier addiert sich dann Rauschen zum Nutzsignal, was zu unscharfen Konturen bis hin zur völligen Signalauflösung führt.

Ein Vorteil bei der digitalen Datenübertragung oder -speicherung besteht zum einen generell darin, daß die Anforderungen an ein Übertragungssystem, das lediglich ein Signal mit binären Informationen überträgt hinsichtlich seiner Linearität erheblich geringer sind, als die Forderungen an ein Übertragungssystem, welches Analogsignale z.B. Musik mit hoher Qualität übertragen soll. Ein weiterer Vorteil beseht darin, daß Rauschen und andere kleine Inbandstörungen solange ignoriert werden, bis sie die digitale Schwelle erreichen.

Dem steht bisher als Nachteil ein großer Bandbreitenbedarf gegenüber, durch welchen die Rauschbandbreite und die Wahrscheinlichkeit von Inbandstörungen zunehmen und somit den Vorteil der Übertragungssicherheit abschwächen. Bei einer derartigen Übertragung digitaler Signale muß wegen der großen Übertragungsbandbreite ein zur Übertragung verwendeter Nachrichtenkanal eine große Übertragungskapazität zur Verfügung stellen, ohne daß diese optimal genutzt wird. Damit lassen sich bei aufwendigen Nachrichtenverbindungen, wie Satellitenkanälen, weniger Informationen übertragen als von der durch das Produkt von Bandbreite und Übertragungszeit definierten Kanalkapazität vorgegeben ist.

Aus US-A-3 697 697 sind ein Verfahren und eine Schaltung zur analogen Übertragung digitaler Signale bekannt, mit denen unter anderem eine Reduzierung der für den Übertragungskanal benötigten Bandbreite erreicht werden soll. Kern dieses Verfahren und dieser Vorrichtung - die auf einem in US-A-3 377 625 offenbarten Verfahren und einer Vorrichtung mit gleicher Zielstellung beruhen - ist die Gewinnung einer Mehrzahl von Übertragungs-Funktionen begrenzter Bandbreite zur analogen Repräsentation digitaler Information zum Zweck ihrer Übertragung aus (trigonometrischen) Basis-Funktionen durch Multiplikation dieser Basis-Funktionen miteinander.

In US-A-3 697 697 ist dieses Grundprinzip mehrstufig in hierarchisch verknüpften Multiplizierstufen realisiert und durch in die Verknüpfungs-Hierarchie eingefügte Additions-Schritte ergänzt, wobei in den Multiplizier-Baugruppen der zweiten Hierarchieebene eine Aufprägung der zu übertragenden Digitalinformation auf die Übertragungs-Funktionen durch Verarbeitung der einzelnen Binärwerte mit den (hier 10 verschiedenen) Basis-Funktionen oder bereits - ebenfalls durch Multiplikation - aus diesen abgeleiteten Funktionen stattfindet.

Die Realisierung dieser Lösung ist aufwendig und wegen ihrer Vielstufigkeit potentiell störanfällig, und sie hat den prinzipiellen Nachteil, daß die Re-Digitalisierung auf der Empfängerseite völlig anders abläuft als die "Analogisierung" auf der Senderseite, womit dem zu übertragenden Signal nicht ohne weiteres senderseitig eine bewußte, vorgegebene Verzerrung aufgeprägt werden kann, die empfängerseitig ohne weiteres wieder durch eine inverse Entzerrung aufgehoben werden könnte.

Der Erfindung liegt die Aufgabe zugrunde, ein Verfahren der eingangs genannten Gattung sowie eine entsprechende Schaltung anzugeben, bei dem die spektrale Bandbreite des für die Übertragung beanspruchten Nachrichtenkanals ein Minimum ist, das einfach zu realisieren und wenig störanfällig ist und die Möglichkeit einer leichten Signalver- und -entzerrung bietet.

Diese Aufgabe wird durch ein Verfahren mit den Merkmalen des Anspruchs 1 bzw. eine Schaltung mit den Merkmalen des Anspruchs 18 gelöst.

Bei dem erfindungsgemäßen Verfahren wird das digitale Siggnal nicht, wie bei der konventionellen Übertragung, in Form von binären Informationen in zeitlich serieller Folge ausgestrahlt. Statt dessen wird ein Bitmuster, also mehrere zusammengefaßte Bits, einem analogen, amplitudenmäßig quantisierten Schwingungszug (Gesamtschwingungszug) zugeordnet. Dieser Spannungsverlauf wird übertragen und auf der Empfängerseite in das ursprüngliche Bitmuster zurückverwandelt. Die unterschiedlichen Spannungsverläufe sind gequantelt und zwar in solcher Weise, daß die Quantensprünge mindestens in gleicher Zuverlässigkeit detektiert werden können wie die binären Zustände der konventionellen Datenübertragung. Es bleibt also der nachrichtentechnische Vorteil der Digitalübertragung, nämlich die klare Detektierbarkeit der jeweiligen Zustände, erhalten, ohne daß hierbei der mit der konventionellen digitalen Datenübertragung verbundene hohe Bandbreitenbedarf erforderlich ist.

Die den Bitmustern zugeordneten Spannungsverläufe bestehen aus der additiven Überlagerung mehrerer z.B. drei Sinusschwingungszügen, deren Amplituden in mehreren Stufen z.B. 4 oder 8 gequantelt sind, deren Periodendauer durch Verdoppelung hervorgehen und deren Phasenlage konstant ist, nämlich 0, zu Beginn eines jeden Übertragungsintervalls.

Insbesondere wird ein impulsförmig einlaufendes Digitalsignal in Abschnitte unterteilt, die mehrere Bits umfassen. Das so gebildete Datenwort wird dem Eingang eines Wandlers zugeführt, der das mehrstufige Analogsignal einer Quantisierungsschaltung zuführt.

Bei dem erfindungsgemäßes Verfahren wird der bei herkömmlichen digitalen Übertragungsverfahren bestehende gravierende Nachteil des hohen Bandbreitenbedarfs trotz voller Beibehaltung der Vorteile einer digitalen Übertragung aufgehoben.

Betrachtet man das Signal nach dem erfindungsgemäßen Verfahren, so ist erkennbar, daß Bandbegrenzungsverzerrungen höchstens im Übergangsbereich zwischen zwei Übertragungsintervallen auftreten könnten, und zwar nur in dem Fall, wenn sich alle Schwingungszüge bei ihrem maximalen Hub (ca. ± 30 kHz bei ± 75 kHz Gesamthub) gleichphasig addieren. Etwaige nichtlineare Verzerrungen im Empfänger sind dann ohne Bedeutung, sofern diese Verzerrungen nicht aus einem Defekt im Empfangsgerät selbst herrühren.

Bei der schaltungstechnischen Realisierung sind Mittel dazu vorzusehen, die zu übertragenden Signale in Form von Teilschwingungen enthaltenden Schwingungszügen übertragen.

Von besonderer Bedeutung ist hierbei die sichere Amplitudenerfassung der drei Teilschwingungen bei der empfängerseitigen Decodierung.

Hierbei wird insbesondere die Tatsache ausgenutzt, daß jeweils einzelne Teilschwingungen sich zu bestimmten Zeitpunkten - oder gemittelt über bestimmte Zeitbereiche - aufheben, so daß dann die Amplitudenwerte einzelner Teilschwingungen getrennt zur Auswertung zur Verfügung stehen.

So ist es insbesondere günstig,
- die Teilschwingung des Schwingungszugs mit der niedrigsten Frequenz von den Schwingungszügen mit höherer Frequenz spektral zu trennen, wodurch
1. höherfrequente Rauschanteile reduziert werden,
2. die Steilheit des Spannungsverlaufes im Abtastpunkt verringert wird, wodurch Abtastzeitfehler unkritischer werden,
- die höherfrequenten Schwingungszüge im Abtastbereich mehrere Male, insbesondere dreimal, abzutasten, und zwar bei beiden Halbwellen. Da zum Abtastzeitpunkt des einen Schwingungszugs der höchstfrequente Schwingungszug seinen Nulldurchgang, also seine höchste Steilheit aufweist, können hier Abtastzeitfehler zu Spannungsfehlern führen, die jedoch bei beiden abzutastenden Halbwellen unterschiedliche Polarität hätten.

Bei einer im empfängerseitigen Decoder erfolgenden mehrfachen paarweisen Abtastung sind dann dann diejenigen Abtastwerte die richtigen, deren Differenz am geringsten ist, also z.B. die jeweils ersten, zweiten oder dritten Abtastwerte. Das arithmetische Mittel dieses Abtastpaares würde mit hoher Näherung dem richtigen Abtastwert entsprechen.

- Während die Schwingungszüge niederer Frequenz beim Nulldurchgang des jeweils höheren Schwingungszuges abgetastet werden müssen, kann der Schwingungszug höchster Frequenz, da ihm kein weiterer Schwingungszug überlagert ist, zu jedem Zeitpunkt abgetastet werden und mit diesem Wert der Maximalwert berechnet und auf die Quantelungsstufe geschlossen werden. Hierbei ist der Maximalwert zur Abtastung günstig; zur weiteren Sicherheit sind jedoch ein oder zwei weitere Abtastwerte durchaus geeignet.

Wirtschaftlich besondere Bedeutung hat das erfindungsgemäße Verfahren für die digitale Übertragung von Rundfunk Stereo-Programmen.

Bei einer Abtastrate des Stereo-Programms von 40 kHz (20 kHz pro Kanal) und einer Auflösung von 8 Bit wäre bei einer HF-Übertragungsbandbreite von ca. 320 kHz nicht nur eine Ausstrahlung über Satellit, sondern auch über terrestrische Kanäle möglich. Damit ist es möglich, auch die große Zahl der in Kraftfahrzeugen vorhandenen ortsbeweglichen Empfänger mit einem störungsfreien Digitalprogramm hoher Qualität zu versorgen.

Durch das erfindungsgemäße Verfahren kann bei Satellitenausstrahlung die Kanalkapazität gegenüber der konventionellen Datenübertragung vervierfacht werden. Bei gleicher Sendeleistung würde sich der Antennenaufwand erheblich verringern und die Reichweiten würden sich erhöhen. Entsprechendes gilt für digitales Fernsehen (D2MAC). Weitere bevorzugte Anwendungen bestehen beim Studio und im Funkbereich.

Für Musikübertragung hoher Qualität sind bevorzugt Frequenzen der Schwingungszüge von 10 kHz, 20 kHz und 40 kHz entsprechend einer Bandbreite von 160 kHz zu verwenden. Bei der Übertragung und Speicherung von digitalen Informationen lassen sich bei vorgegebener Kanalbandbreite Datenraten übertragen, die ungefähr dreimal größer sind als die derzeit üblichen Datenraten bei entsprechenden Bedingungen.

Die für die Datenübertragung maßgeblichen Überlegungen sind jeweils entsprechend auf Speichermedien anzuwenden, wobei jeweils die Eigenschaften des Speichermediums diejenigen des Übertragungsmediums ersetzen.

Besonders vorteilhaft bei der Rückgewinnung der Ausgangsinformation ist es, wenn die Amplitudenwerte des Gesamtschwingungszugs so abgetastet oder ausgewertet werden, daß mindestens ein anderer oder alle anderen Teilschwingungszüge ihren Nulldurchgang haben bzw. zu Null werden. Auf diese Weise lassen sich zunächst die gequantelten Amplituden einzelner Schwingungszüge wiedergewinnen. Wegen der phasenstarren Übertragung werden bei einer günstigen Weiterbildung der Erfindung die ermittelten Amplitudenwerte der Teilschwingungszüge benutzt, um deren Auswirkung auf die Momentanamplituden der anderen Teilschwingungszüge zu den anderen Abtastzeitpunkten zu ermitteln und zu kompensieren. Auf diese Weise läßt sich der Signalverarbeitungsaufwand bei der Decodierung sehr stark verringern.

Bei einer empfängerseitigen Decodierung durch die Signale zeitlich ausmittelnde Integratoren werden bei einer bevorzugten Ausführung der Erfindung die Zeitintervalle für die Integration innerhalb eines Übertragungsintervalls derart gewählt, daß für das jeweilige Integrationsintervall der Anteil eines, mehrerer oder insbesondere aller anderen Schwingungszüge gleich Null ist, so daß das Integral einzelner, oder insbesondere eines einzelnen, Schwingungszugs - und damit auch dessen Amplitudenwert - separat ausgewertet werden kann. Diese Bedingung ist insbesondere dann erfüllt, wenn der Integrator eine Umpolschaltung aufweist, welche das Eingangssignal synchron mit der Polarität des auszuwertenden Teilwellenzugs in seiner Polarität ändert.

Wegen der digitalisierten Information kommt es bei der Decodierung auch hierbei lediglich auf die Diskriminierung einzelner Amplitudenklassen an, denen digitale Informationen zugeordnet sind. Bei der Decodierung mittels Integration ergibt sich insbesondere der Vorteil, daß auch kurzfristige Signaleinbrüche und hochfrequente Störungen eliminiert werden. Der Integrationsvorgang selbst bewirkt, daß die Signalamplituden des empfangenen Signals nicht nur zu diskreten Zeitpunkten, sondern weitgehend kontinuierlich ausgewertet werden, so daß eventuelle kurfristige Störungen einen nur geringen Anteil des Nutzsignals ausmachen und infolgedessen nur entsprechend gering ins Gewicht fallen.

Das Prinzip des erfindungsgemäßen Verfahrens soll eingangs zunächst anhand von zwei Darstellungen allgemein näher erläutert werden. Es zeigen:

Figuren 1 und 1a schematische Darstellungen zur Erzeugung des bei dem erfindungsgemäßen Verfahren zu übertragenden Signals,

Figur 2 eine schematische Darstellung zur Lage der Abtastpunkte bei dem erfindungsgemäßen Verfahren.

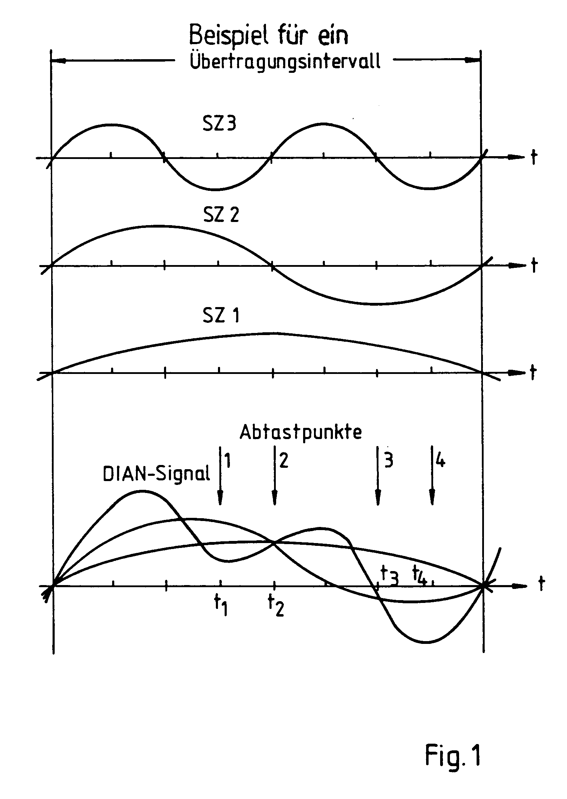

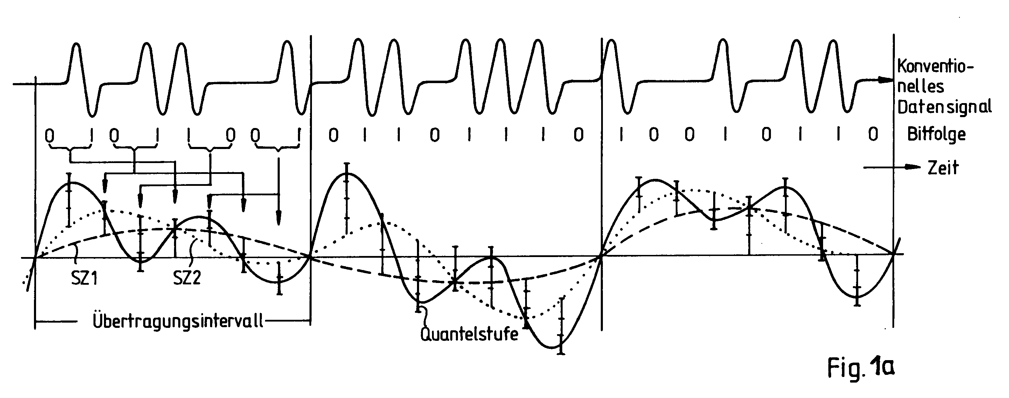

Bei dem in Figur 1 dargestellten Diagramm sind die als Informationsträger dienenden Schwingungszüge (SZ1 bis SZ3) eines Übertragungsintervalls in der oberen Darstellung einzeln und in der Überlagerung unten wiedergegeben. Bei dem erfindungsgemäßen Verfahren werden den einzelnen Schwingungszügen eines Übertragungsintervalls binäre Informationen zugeordnet. Die sinusförmigen Schwingungszüge, die in einem festen Frequenzverhältnis zueinander stehen, werden in phasenstarrer Lage übertragen. Bevorzugt unterscheiden sich die Frequenzen der Schwingungszüge jeweils um den Faktor zwei.

Jeder Amplitude einer Halb- oder Vollwelle ist jetzt ein digitaler Anteil des zu übertragenden Signals zugeordnet. Dabei wird eine, vorzugsweise ein Datenwort bildende, Informationseinheit in Teilworte entsprechenden Untereinheiten zerlegt. Die einem Teilwort entsprechende digitale Information wird jeweils der Amplitude eines Schwingungszugs zugeordnet, und zwar in der Weise, daß die Amplitude in Quantensprüngen entsprechend dem jeweiligen Digitalwert der Teilinformation veränderlich ist.

Erfolgt nun beispielsweise die Quantelung
SZ 1 (Halbwelle) in 4 Stufen ≙ 2 bit
SZ 2 (Vollwelle) in 4 Stufen ≙ 2 bit
und SZ 3 (Vollwelle) in 4 Stufen ≙ 2 bit,
so läßt sich ein Datenwort von insgesamt 8 bit pro Intervall übertragen.

Auf diese Weise lassen sich die Vorteile der Störsicherheit bei der Übertragung digitaler Signale auf mit Analogschaltungsmitteln arbeitende Übertragungswege anwenden. Die erhöhte Störsicherheit beruht auf der Tatsache, daß die verwendeten Quantensprünge eine Resistenz gegen Amplitudenbeeinträchtigungen des zu übertragenden Signals sicherstellen, insbesondere, was die bei auf elektromagnetischen Wellen basierenden Übertragungswegen dominierenden Überlagerungen von Rausch- oder sonstigen Störsignalen betrifft. Durch die erfindungsgemäße frequenzmäßige Verschachtelung der die Informationen tragenden Signale und bedingt durch deren der Sinusform mindestens angenähertem zeitlichen Verlauf wird für die Übertragung des Gesamtsignals lediglich eine geringe Gesamtbandbreite benötigt. Die Übertragung des die digitale Information in analoger Form enthaltenden Signals erfolgt bevorzugt in bekannter Weise mittels FM-Modulation. Wegen des begrenzten Hubs ist auch hier der spektrale Bedarf des FM-Signals klein, so daß es sich bevorzugt für die Übertragung auf kommerziellen Nachrichtenkanälen wie beispielsweise für Satellitenprogramme eignet.

Für die weiter unten folgende Beschreibung der Ausführungsbeispiele wird von dieser Quantelung ausgegangen.

Figur 1a wiederholt die Darstellung eines Schwingungszugs entsprechend dem unteren Kurvenverlauf in Figur 1, jedoch über mehrere Wellenzüge, wobei die entsprechenden Informationsanteile zusätzlich als Bitmuster und als Signalverlauf in Form eines Impulszuges dargestellt sind.

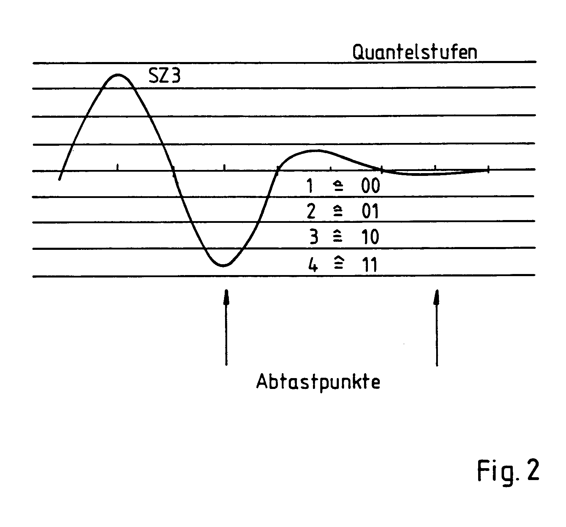

Der spektrale Bedarf ist im wesentlichen durch den Teilschwingungszug mit der höchsten Frequenz festgelegt. Begrenzt man die Bandbreite des Übertragungskanals auf die erste Harmonische dieser Frequenz, so wird zwar die auf einen Amplitudensprung folgende Halbwelle durch ein Nachschwingen etwas verfälscht, bei der 2. Halbwelle jedoch ist die Überschwingung soweit abgeklungen, daß sie deutlich unterhalb der nächsten Quantenstufe liegt (Figur 2). Auf der Empfängerseite wird daher stets die Amplitude der 2. Halbwelle ausgewertet.

Während bei dem erfindungsgemäßen Verfahren gemäß Ausführungsbeispiel in einem Übertragungsintervall 8 bit übertragen werden, so könnte bei der konventionellen Datenübertragung unter der Voraussetzung, 1 Bit entspricht einem Schwingungszug SZ3, nur 2 Bit übertragen werden, d.h., zur Übertragung der gleichen Datenrate müßte die Frequenz des Datenträgers um den Faktor 4 erhöht werden.

Vergleicht man also den spektralen Bedarf des erfindungsgemäßen Verfahrens mit dem einer konventionellen Datenübertragung unter der Voraussetzung, daß bei dieser ein Schwingungszug einem bit entspricht (höchstmögliche Datenrate bei vorgegebenem Spektrum) und auch hier im Spektrum lediglich die 1. Harmonische zugelassen wird, so ergibt sich beim erfindungsgemäßen Verfahren in der oben dargestellten Viererquantelung 1/4 des Bandbreitenbedarfs. Eine Übertragung beim erfindungsgemäßen Verfahren zum Beispiel mit Schwingungszügen der Frequenzen 80 kHz, 40 kHz, 20 kHz bedürfte zur einwandfreien Auswertung

$$4 \times 80 \text{ kHz} = 320 \text{ kHz.}$$

Eine konventionelle Übertragung erfordert jedoch für die gleiche Datenrate einen Datenträger der Frequenz

$$8 \times 40 \text{ kHz} = 320 \text{ kHz}$$

und ein Spektrum von ca.

$$4 \times 320 \text{ kHz} = 1,28 \text{ MHz.}$$

Vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen:

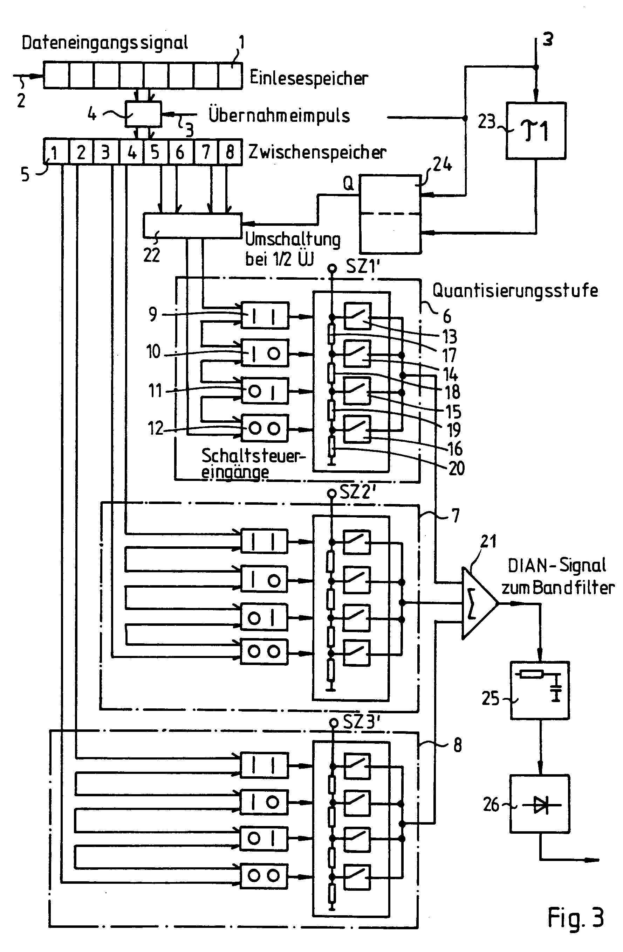

Figur 3 ein Schaltung zur Ausführung des erfindungsgemäßen Verfahrens in Blockdarstellung,

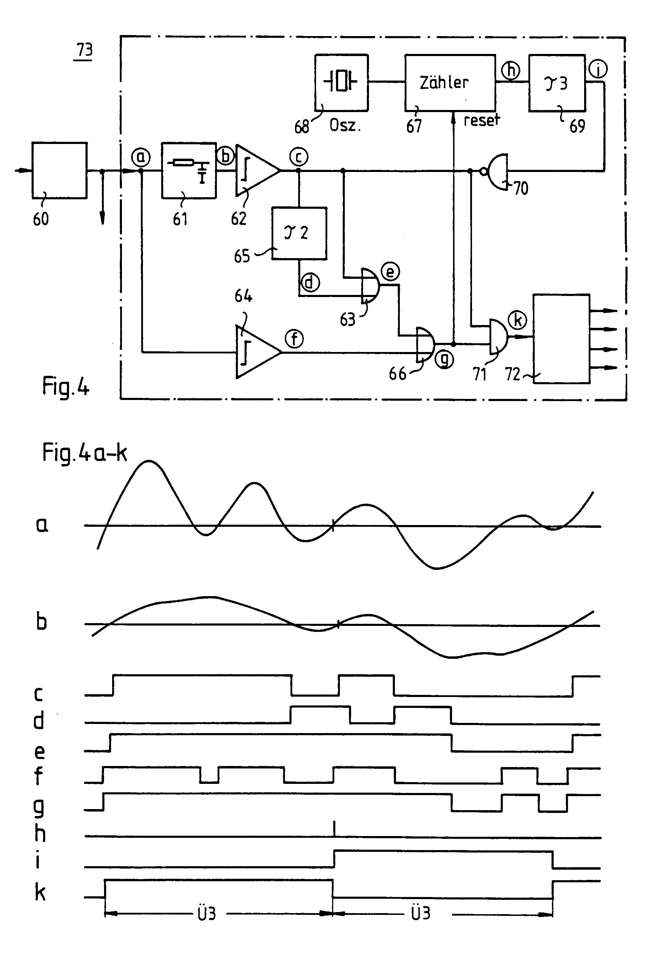

Figur 4 eine Schaltung zur Synchronisation bei der Rückgewinnung des übertragenen Signals,

Figuren 4a bis k Darstellungen der zeitlichen Verläufe von in der Schaltung gemäß Figur 4 auftretenden Signalen,

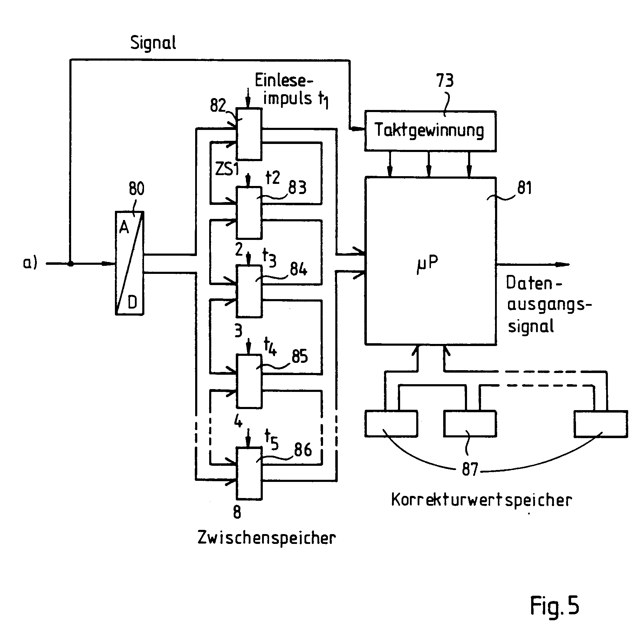

Figur 5 eine Schaltung zur Datenrückgewinnung für das erfindungsgemäße Verfahren,

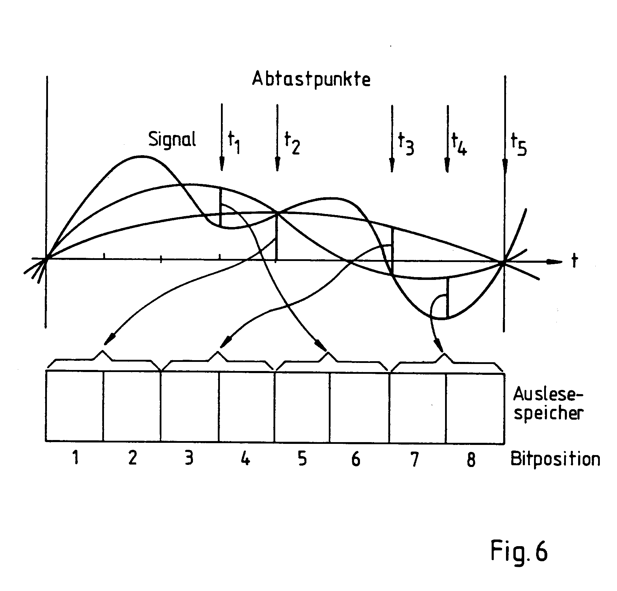

Figur 6 eine schematische Darstellung zur Rückgewinnung der nach dem erfindungsgemäßen Verfahren übertragenen Information,

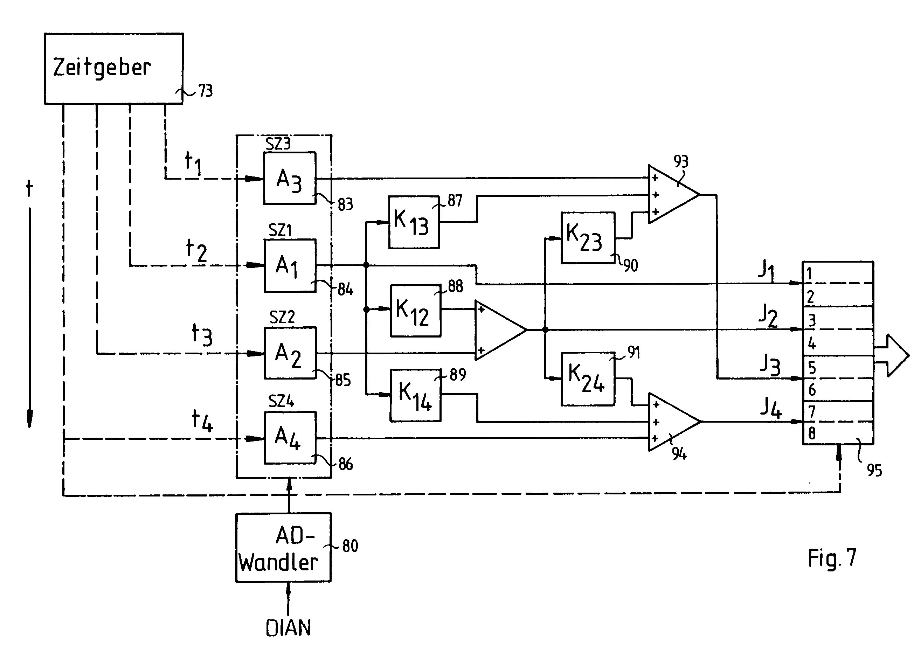

Figur 7 ein weiteres vorteilhaftes Ausführungsbeispiel einer Decoderschaltung zur Anwendung auf ein Signal gemäß Figur 6,

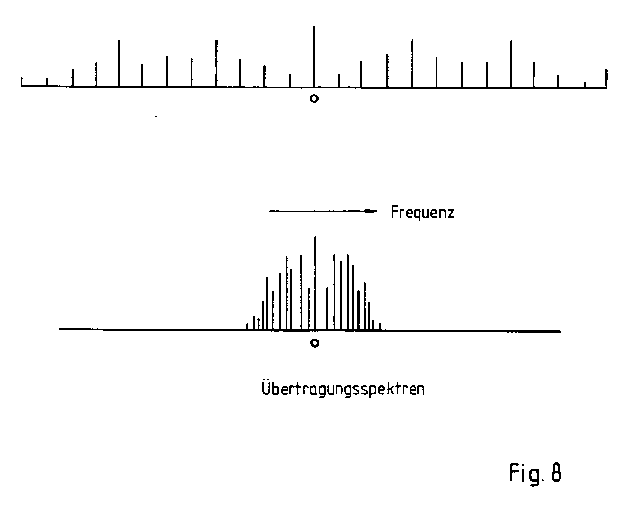

Figur 8 eine Darstellung der spektralen Verteilung der nach dem erfindungsgemäßen Verfahren zu übertragenden Signale im Vergleich zu nach dem Stand der Technik arbeitenden Verfahren sowie

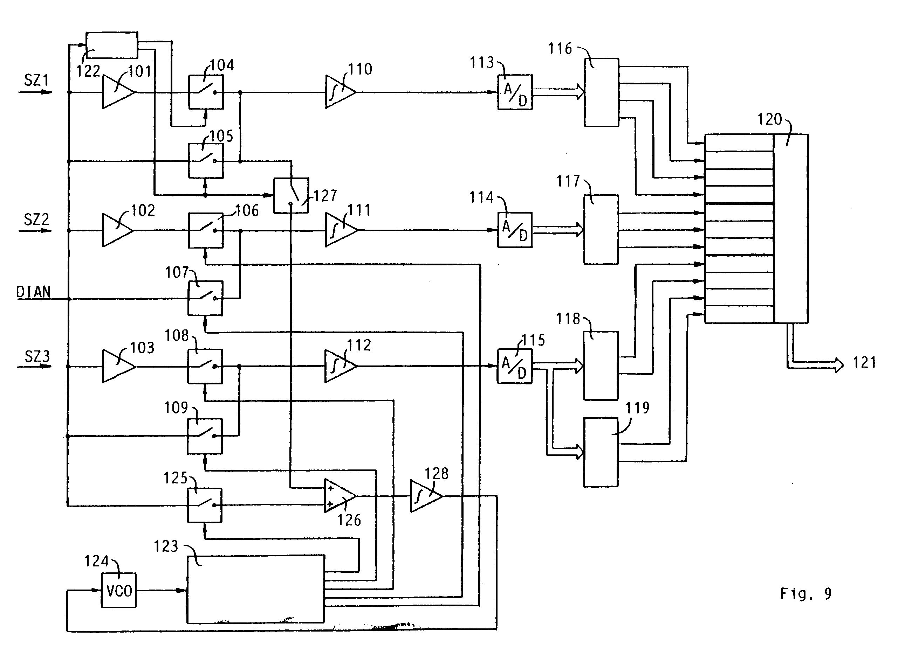

Figur 9 eine Variante einer Decoderschaltung, die nach dem Integrationsprinzip arbeitet.

Ein Ausführungsbeispiel eines senderseitigen Codierers zur Realisierung des erfindungsgemäßen Verfahrens ist in Figur 3 dargestellt.

Das Dateneingangssignal wird in einen 8-bit-Speicher 1 eingelesen, der als Schieberegister ausgebildet ist. Nach Abschluß des Einlesezyklus, in dem ein in einem Übertragungsintervall auszusendendes "Datenwort" aus dem über einen Eingang 2 einlaufenden Datenstrom entnommen wird. Auf einen Übernahmeimpuls 3, der zum Eingang einer Torschaltung 4 gelangt, kopiert diese den Inhalt des Schieberegisters in einen Zwischenspeicher 5.

Jeweils zwei aufeinanderfolgende Bitpositionen dieses Zwischenspeichers 5 sind mit dem Eingang eines Digital-Analog-Wandlers 6 bis 8 verbunden. Diese Wandler setzen die jeweils 2 Bit umfassenden Informationen in entsprechende Analogwerte um, die im vorliegenden Ausführungsbeispiel entsprechend in jeweils vier Stufen gequantelt sind.

Bei der dem Zwischenspeicher 5 nachfolgenden Quantisierungsstufe (Schaltungen 6 bis 8) wird jeder Bitkombination ein definierter Analogwert zugeordnet, der frei festlegbar ist. Auf diese Weise ist es beispielsweise möglich, nichtlineare Vorverzerrungen zu erzeugen, um die Amplitudensprünge den vorgefundenen Störbedingungen des Übertragungskanals anzupassen. So können beispielsweise die Digitalsignalen entsprechenden Analogquantenwerte einem festen analogen Minimalwert hinzugefügt werden, der eine Phasenreferenz bildet.

Bei der als Beispiel zu beschreibenden Quantisierungsstufe 6 sind vier Detektionsschaltungen 9 bis 12 parallel mit dem Eingang verbunden und geben ein logisches Aktivsignal ab, wenn die zugeordnete Bit-Kombination am Eingang anliegt. Eine derartige Schaltung besteht in der technischen Realisierung vorzugsweise aus logischen Verknüpfungschaltungen, wie logischen Gattern, welche auf die dargestellte Bit-Kombination am Eingang das die nachfolgende Schaltung aktivierende Signal abgeben.

Die Ausgänge der Detektionsschaltungen sind verbunden mit Steuereingängen von Schaltern 13 bis 16, welche Abgriffe eines aus Widerständen 17 bis 20 gebildeten ohmschen Spannungsteilers wechselweise mit dem Ausgang verbinden. An den Eingängen der Spannungsteiler stehen die sinusförmigen Grundspannungsverläufe SZ1' bis SZ3' für die entsprechenden Teilschwingungszüge zur Verfügung. Die entsprechend der Stellung der Schalter 13 bis 16 amplitudenmäßig veränderten Spannungsverläufe erscheinen als Teilschwingungszüge SZ1 bis SZ3 an den Ausgängen der Schaltungen 6 bis 8. Der sinusförmige Verlauf der Spannungen bleibt dabei erhalten - die Amplitudenveränderung entspricht der Multiplikation der Momentanwerte mit einem Faktor (Attentuierung).

Die Ausgangsspannungen der Quantisierungsstufen 6 bis 8 werden über eine Summationsschaltug 21 additiv verknüpft. Diese besteht vorzugsweise aus einer entsprechenden bekannten, einen Operationsverstärker aufweisenden Schaltung.

Während die Quantisierungsstufen 7 und 8 für die Bitpositionen 1 bis 4 des Zwischenspeichers 5 ihren Schaltzustand jeweils für eine Vollwelle des Sinussignals beibehalten, schaltet die Quantisierungsstufe 6 nach jeder Halbwelle des Sinussignals SZ1' um. Dazu werden die Bitpositionen 5, 6 und 7, 8 (bezogen auf den Zwischenspeicher 5) mittels eines Umschalters 22 zeitlich nacheinander für je einen halben Übertragungszyklus der Quantisierungsstufe 6 zugeleitet. Dieser Umschalter wird gesteuert von einem Verzögerungsglied 23, dessen Eingang der am Eingang der Schaltung 4 anstehende Übernahmeimpuls 3 zugeleitet wird. Der Umschalter wird durch ein am Q-Ausgang eines Flip-Flops 24 erscheinendes Signal in eine der vorgegebenen Positionen gesetzt und fällt bei fehlendem Signal in die andere Position zurück. Das Flip-Flop 24 wird über seine beiden Eingänge durch den Übernahmeimpuls bzw. durch den um $\tau$ = $\frac{1}{2}$ $T_{\ddot{U}}$ (halber Übertragungszyklus entsprechend $\frac{1}{2}$ $T_{SZ1}$) verzögerten Impuls am Ausgang der Schaltung 23 zwischen seinen beiden stabilen Schaltzuständen umgesetzt.

Jeder Bitgruppe ist somit eine Quantisierungsstufe zugeordnet, in welcher ein Sinusschwingungszug in vier Stufen gequantelt und über Schalter zu nachfolgenden Schaltungen geleitet wird. Diese Anordnung gewährleistet eine eindeutige Zuordnung des 8-Bit-Datenwortes zu den Schalterstellungen bzw. zur Zusammensetzung des gemäß dem erfindungsgemäßen Verfahren zu übertragenden Signals. Die durchgeschalteten Schwingungszüge gelangen nach der Addition als Summensignal über einen Tiefpaß 25 mit einer oberen Frequenzgrenze entsprechend etwa 2 $f_{SZ3}$ zu einem FM-Modulator 26. Der FM-Modulator setzt das nach dem erfindungsgemäßen Verfahren verarbeitete Signal in ein Frequenzgemisch um, das vorzugsweise als Funksignal abgestrahlt werden kann. Wegen des relativ kleinen Frequenzhubes weist es insoweit günstige Eigenschaften auf, als das benötigte Frequenzband relativ schmal und die Beeinflussung von Nachbarkanälen vernachlässigbar gering ist.

Eine zur empfängerseitigen Regeneration des nach dem erfindungsgemäßen Verfahren übertragenen Digital-Signals günstige Schaltung ist in den Figuren 4 und 5 wiedergegeben.

Bei dem Signal müssen zunächst zwecks Synchronisation Anfang und Ende eines Übertragungszyklus sowie die Lage der Abtastpunkte ermittelt werden.

Bei der in Figur 4 dargestellten Synchronisationsschaltung zur Ermittlung des Taktes wird die zeitliche Lage der Übertragungszyklen durch die Null-Durchgänge des langsamsten Schwingungszuges SZ1 für jeweils einen Zyklus ermittelt. (Die in den Figuren 4a bis k wiedergegebenen Schwingungszüge treten an Schaltungspunkten auf, die mit den entsprechenden Buchstaben a bis k bezeichnet sind.)

Hierzu wird das empfangene und mittels eines FM-Demodulators 60 demodulierte Signal (a) über einen diesem nachgeschalteten Tiefpaß 61 geleitet, welcher die Pegel der Frequenzanteile der Signale SZ3 und SZ2 soweit absenkt, daß durch SZ3 keine weiteren Null-Durchgänge verursacht werden und die durch SZ2 verursachten Null-Durchgänge relativ dicht zusammenrücken (Signal b). Das derart tiefpaßgefilterte Signal gelangt zum Eingang eines Begrenzerverstärkers 62, dessen Ausgangssignal eine Rechteckimpulsfolge mit jeweils einem längeren und einigen kürzeren Impulsen darstellt (c).

Die ansteigende Flanke des längeren Impulses markiert den Anfangspunkt eines Übertragungsintervalls. Es bildet ein Phasen-Referenzsignal für die Frequenz ZS1. Zur Unterdrückung der zweiten ansteigenden Flanke - nämlich der des kürzeren Impulses - erfolgt mittels eines nachgeschalteten ODER-Gatters 63 eine ODER-Verknüpfung dieses Signals mit dem Ausgangssignal (d) einer weiteren Verzögerungsstufe 65, bestehend beispielsweise aus einem monostabilen Multivibrator, welcher durch die Rückflanken der Rechtecksignale getriggert wird. Am Ausgang des ODER-Gatters 63 erscheint das Signal e), dessen Impulsfrequenz mit ZS1 übereinstimmt, also keine zusätzlichen ansteigenden Flanken mehr aufweist.

Da das tiefpaßgefilterte Signal b) geringfügig gegenüber dem unverfälschten Eingangssignal a) in der Phase verschoben ist, liegt der exakte Beginn eines Übertragungsintervalls vor der ermittelten ansteigenden Flanke des Signals c). Eine Korrektur der zeitlichen Position des Beginns des Übertragungsintervalls erfolgt mittels eines zusätzlichen Begrenzerverstärkers 64, dem das Eingangssignal a) direkt zugeleitet wird. Das Ausgangssignal f) des Verstärkers 64, das die korrekte Anstiegsflanke des das Übertragungsintervall kennzeichnenden Bezugssignals aufweist wird mittels eines ODER-Gatters 66 mit dem Ausgangssignal des ODER-Gatters 63 verknüpft. Am Ausgang des ODER-Gatters 66 erscheint das Signal g), das im wesentlichen dem Signal e) enspricht, dessen erste ansteigende Flanke aber in ihrer zeitlichen Position korrigiert ist.

Die ODER-Verknüpfung beider Signale liefert somit einen längeren Rechteckimpuls, dessen ansteigende Flanke den exakten Beginn des Übertragungsintervalls darstellt mit einigen nachfolgenden kürzeren Rechteckimpulsen (Signal g). Die gewünschte ansteigende Flanke kann jedoch immer noch nicht unmittelbar ausgewertet werden, da ihr mehrere "falsch" ansteigende Flanken folgen können.

Ein eindeutiges Anfangssignal für das Übertragungsintervall wird mittels eines zusätzlichen Zeitdiskriminators in Form eines Frequenzzählers 67 gewonnen, der mit einem hochfrequenten (hier: 10,24 MHz) Taktsignal aus einem Quarz-Oszillator 68 gespeist wird und dessen Zählperiode so gewählt ist, daß sie exakt einem Übertragungsintervall (ÜI) - also der halben Periode des Signals SZ1 - entspricht. Dadurch, daß das invertierte Rechtecksignal g) vom Ausgang des ODER-Gatters 66 auf den Reseteingang des Zählers 67 geleitet wird, so kann der Zähler nur während des langen Impulses seinen Zählerendstand erreichen, also einen Übertragungsimpuls (Signal h) abgeben. Der Zeitdiskriminator "sucht" somit diejenigen Impulszeiten, welche die durch seine Zählperiode vorgegebene Mindestzeitdauer überschreiten, so daß eine "Synchronisation" der Auswertung mit diesen Impulsen vorgegebener Mindestzeitdauer erfolgt.

Mit dem Übertragungsimpuls h) als Ausgangssignal des Freguenzzählers 67 wird über einen Zeitgeber 69 mit einer Zeitkonstante $\tau_3$ ein Signal i) erzeugt. Dieses Signal i) wird mittels eines Inverters 70 invertiert und mit dem Rechtecksignal g) als Ausgangssignal des ODER-Gatters 66 über ein UND-Gatter 71 zu dem Signal k) verknüpft, welches das gewünschte Rechtecksignal als Bezugssignal für die Decodierung, dessen Impulslänge dem Übertragungsintervall entspricht, bildet.

Eine Schaltung 72 zur Erzeugung der einzelnen Synchronisationsimpulse zur Gewinnung der Abtastpunkte beinhaltet einen Zeitgeber, der in fester Zeitrelation zu einer - hier: ansteigenden Eingangsimpulsflanke - in jeweils für jeden Ausgang vorgegebenem Zeitabstand einen Ausgangsimpuls abgibt. Die Ausgangsimpulse entsprechen dabei in ihrer zeitlichen Lage den Abtastpunkten gemäß Figur 6. Technisch realisierbar ist eine derartige Schaltung durch einen durch das Eingangssignal vom Ausgang des UND-Gatters 71 regelmäßig zurückgesetzten - und beispielsweise durch den Oszillator 68 getakteten - Zähler, dessen Ausgangssignale mittels entprechender logischer Gatterschaltungen so verknüpft werden, daß zu den entsprechenden, durch den Zählerstand und damit die entsprechenden Ausgangszustände des Zählers vorgegebenen Zeiten ein Taktimpuls zu dem zugeordneten Ausgang durchgeschaltet wird.

Eine Schaltung zur Rückgewinnung der nach dem erfindungsgemäßen Verfahren übertragenen Datenworte unter Benutzung des durch die Schaltung gemäß Figur 4 gewonnenen Synchronisationsmusters gemäß Figur 6 ist in Figur 5 dargestellt.

Das demodulierte Signal a) gemäß Figur 4 gelangt zu einem Eingang eines Analog-Digital-Wandlers 80, dessen Auflösung erheblich genauer ist (etwa um den Faktor $2^8$) als die Quantenstufung des Nutzsignals. Der Digital-Analog-Wandler ordnet jedem Eingangsanalogwert einen sogenannten "Fensterwert" zu, wobei die jeweiligen Fensterbereiche der von der zuvor dargestellten Schaltung vorgenommenen Quantisierung entsprechen. Da jedes Fenster eine relativ große Zahl von benachbarten erfaßbaren Analogwerten umfaßt, wird damit die Übertragungssicherheit stark heraufgesetzt.

Die aus den Analogwerten abgeleiteten Digitalwerte, die zu den Abtastzeitpunkten t1 bis t4 gehören, werden mittels der CPU ($\mu$P) 81 eines Mikroprozessors in Zwischenspeicher 82 bis 85 übertragen und stehen zur Ermittlung der Abtastwerte innerhalb des jeweiligen Übertragungsintervalls zur Verfügung. Die Schaltung zur Taktgewinnung 73 entspricht dabei der in Figur 4 detailliert dargestellten Schaltung. Den in den Zwischenspeichern 82 bis 85 enthaltenen Digitalwerten sind Korrekturwerte in dem Korrekturwertspeicher 87 zugeordnet, wobei die Korrekturwerte für jeden Teilschwingungszug SZ1 bis SZ3 diejenigen Amplitudenwerte bilden, um die jeweils die anderen Teilschwingungszüge wegen der summierenden Überlagerung zu korrigieren sind. Die Korrekturwerte beziehen sich jeweils auf die zeitlich definiert gestaffelten Abtastpunkte. Wegen der festen Phasenbeziehungen der Teilschwingungszüge untereinander und des bekannten Zusammenhangs des funktionalen Amplitudenverhaltens der einzelnen Teilschwingungszüge zu den einzelnen Abtastzeitpunkten kann aus den zu den Abtastzeiten ermittelten Werten auf die den Teilschwingungszügen zugeordneten Teildaten zurückgeschlossen werden.

Die korrigierten Digitalwerte bilden zusammen wieder das in dem Übertragungsintervall übertragene Datenwort, welches im Speicher 31 der senderseitigen Schaltung gemäß Figur 3 enthalten war. Der genaue Ablauf der Verarbeitung ist weiter unten anhand eines mit diskreten Schaltungsbaugruppen aufgebauten Ausführungsbeispiel, wie es in Figur 7 dargestellt ist, näher beschrieben. Die dort dargestellte Signalverarbeitung läßt sich entsprechend mit programmierter Logik erreichen, wobei die dargestellten Speicherbaugruppen durch die dem Prozessor zugeordneten Speicher gebildet werden. Die mathematischen Verknüpfungen werden entsprechend durch das Programm aufgerufen.

Bei dem Abtastzeitpunkt t2, dem Maximum von SZ1, haben die anderen Schwingungszüge ihren Nulldurchgang, liefern also keinen Spannungsbeitrag, so daß dieser Wert dem richtigen Amplitudenwert von SZ1 entspricht.

Fenster 1 =     00 (niedrigster Amplitudenwert)
Fenster 2 =     01
Fenster 3 =     10
Fenster 4 =     11 (höchster Amplitudenwert)

Danach werden die beiden den Fenstern zugeordneten Bits entsprechend der senderseitigen Zuordnung in die ersten beiden Bitpositionen des noch freien Auslesespeichers eingeschrieben (Figur 6). Als nächstes werden die Bits für die Positionen t3 und t4 für den Auslesespeicher ermittelt, welche dem Abtastzeitpunkt t3 zugeordnet sind.

Bei dem Abtastzeitpunkt t3 weist zwar SZ3 einen Nulldurchgang auf; es überlagert sich jedoch ein Spannungswert von SZ1, welcher zur Ermittlung der richtigen Quantelungsstufe von SZ2 subtrahiert werden muß. Hierzu sind jeder Quantelungsstufe von SZ1 zwei Korrekturwerte zugeordnet, und zwar einmal zur Korrektur des Abtastwertes zum Zeitpunkt t3 und dann später der Abtastwerte zu den Zeitpunkten t1 und t4.

Die Auflösung der Korrekturwerte entspricht derjenigen des AD-Wandlers 80. Dem Korrekturwert liegt nicht etwa der aktuell abgetastete Wert zugrunde - dieser gibt lediglich das Fenster vor - ihm liegt vielmehr der exakte Mittelwert im Fenster, also der ideale Wert, der ohne Übertragungsverfälschung vorläge, zugrunde.

Nachdem nun vom aktuellen Abtastwert zum Zeitpunkt t3 der Korrekturwert für SZ1 subtrahiert wurde, wird wiederum über digitale "Fenster" ermittelt, welche Quantelungsstufe von SZ2 vorliegt und entsprechende Bitkombination in die Positionen t3 und t4 des Auslesespeichers eingeschrieben.

Die Abtastwerte t1 und t4 stellen die Summe aus Spannungsbeiträgen aller drei Kurvenverläufe SZ1 bis SZ3 dar. Zur Ermittlung der Quantelungsstufen von SZ3 müssen folglich Korrekturwerte von SZ2 und SZ1 berücksichtigt werden.

SZ2 weist pro Quantelungsstufe einen Korrekturwert für SZ3 auf, welcher aufgerufen, mit dem für diese Abtastzeit zuständigen 2. Korrekturwert von SZ1 addiert und von den aktuellen Abtastwerten t1 und t4 abgezogen wird. Nun wiederum kann die Quantelung von SZ3 zu den Zeiten t1 und t4 ermittelt und die Bitpositionen 5 bis 8 des Auslesespeichers belegt werden.

Eine diskrete Bauelemente aufweisende Schaltung zur Ausführung der zuvor dargestellten Rechenoperationen ist in Figur 7 dargestellt. Diese Schaltung soll nunmehr ebenfalls unter Bezugnahme auf Figur 6 beschrieben werden:
Der Zeitgeber 73 veranlaßt zu den Zeitpunkten $t_1$ bis $t_4$ die Übernahme der abgetasteten, digitalen Fenstern zugeordneten Digitalwerte A1 bis A4 vom AD-Wandler 80 in Speicher 83 bis 86, die vorzugsweise als Schieberegister ausgebildet sind, so daß zum Zeitpunkt $t_4$ alle angegebenen Amplitudenwerte $A_1$ bis $A_4$ zur Weiterverarbeitung unter paralleler Auslesung zur Verfügung stehen.

Die abgetasteten Werte $A_1$ bis $A_4$ führen dabei zu den die Bitwerte repräsentierenden Informationen $I_1$ bis $I_4$ nach folgenden Formeln:

Bitwerte 1,2:     $I_1 = A_1$
Bitwerte 3,4:     $I_2 = A_2 + K_{12}$
Bitwerte 5,6:     $I_3 = A_3 + K_{13} + K_{23}$
Bitwerte 7,8:     $I_4 = A_4 + K_{14} - K_{24}$

Die Abtastung erfolgt dabei in der Reihenfolge:

$t_1$:     $A_3$ (von SZ3)
$t_2$:     $A_1$ (von SZ1)
$t_3$:     $A_2$ (von SZ2)
$t_4$:     $A_4$ (von SZ3)

Durch die abgetasteten Werte werden in den Korrekturwertspeichern 87 bis 91 in Abhängigkeit von den ermittelten Werten Korrekturwerte ausgelesen, welche den Anteil des jeweiligen Teilschwingungszugs in seiner Auswirkung auf die anderen Teilschwingungszüge, bezogen auf die zeitlich versetzten Abtastzeitpunkte, kompensieren. Diese Korrektur ist möglich wegen der starren Phasenzuordnung der einzelnen Teilschwingungszüge. Die Korrekturwertspeicher bilden also "Tabellen", welche in Abhängigkeit von den digitalen Eingangswerten adressiert werden. Die Indizes sind dabei zusammengesetzt aus der (beeinflussenden) Eingangsgröße (n-) und zu beeinflussenden Zielgröße (-n). Summierglieder 92 bis 94, welche den Korrekturwertspeichern nachgeschaltet sind, fassen die Ausgangssignale der Korrekturwertspeicher mit den zu beeinflussenden Größen summierend bzw. subtrahierend zusammen. Die ermittelten Werte werden in den Ausgangsspeicher 95 bitgerecht übertragen.

Bei einer anderen Ausführungsvariante enthält der adressierte Speicherplatz des Speichers 87 gemäß Figur 5 die zu ermittelnde, in einem Gesamtschwingungszug enthaltene Information - entsprechend einem Datenwort - direkt. Die Decodierung erfolgt durch Adressierung mit den zu den Abtastzeitpunkten ermittelten Fensterwerten der Momentanamplituden, welche jeweils die Adressensignale bilden. Es läßt sich nämlich zeigen, daß jeder in den Speichern 82 bis 86 enthaltenen Digitalinformation das entsprechende die Nutzinformation bildende Datenwort eindeutig zugeordnet werden kann. Bei geeigneter Wahl der Abtastzeitpunkte gehört zu jedem übertragenen Gesamtschwingungszug ein anderes, durch den Analog-Digital-Wandler durch Zusammenfügung der zu den Abtastzeitpunkten ermittelten Fensterwerte erhaltenes "Bitmuster".

Die Decodierung kann dann mittels einer "Nachschlagetabelle" sehr schnell erfolgen, sobald die Information eines Übertragungsintervalls (Gesamtschwingungszug) zur Verfügung steht. Diese "Nachschlagetabelle" ist als Speicher nach Art einer Matrix ausgestaltet, wobei die digitalen Speicherinhalte der Zwischenspeicher 82 bis 85 Teile der Adresse einer entsprechenden mehrdimensionalen Matrix bilden können. Gemäß der physikalischen Adressierung des verwendeten Speichers bilden die Teildatenworte der Teilschwingungszüge bevorzugt jeweils bestimmte Speicherbereiche auswählende Teiladressen. Sämtliche eventuell notwendigen Korrekturen des auf diese Weise decodierten Signals lassen sich durch eine entsprechende Ausgestaltung der "Nachschlagetabelle" vornehmen, so daß auf diese Weise jegliche Art von notwendiger Signalverzerrung bzw. -entzerrung im Übertragungskanal erfolgen kann.

In den Figuren 8a und b ist in der Gegenüberstellung des Frequenzbandes eines nach dem Stand der Technik modulierten Datensignals (Figur 8a) mit dem Frequenzband eines nach dem erfindungsgemäßen Verfahren übertragenen Signals (Figur 8b) deutlich, wie sich die erzielte Reduzierung der Bandbreite bei übereinstimmender Datenübertragungsrate auswirkt. Durch "Verdichtung" des Spektrums wird die zur Verfügung stehende Bandbreite bei dem erfindungsgemäßen Verfahren wesentlich besser genutzt. Eine Bandbreitenbegrenzung durch Bandfilterung wurde etwa bei 2•SZ3, also beim doppelten der höchsten benutzten Frequenz für die Analogübertragung, in digitalen Stufungen vorgenommen.

Das in Figur 9 dargestellte Ausführungsbeispiel stellt eine weitere Variante einer Decodierungsschaltung für das erfindungsgemäße Verfahren dar. Hierbei wird die Tatsache ausgenutzt, daß bei Polaritätsumkehr jeweils in den Nulldurchgängen eines Teilsschwingungszugs dieser Signalanteil nicht Null wird, während die Teilschwingungszüge sowohl niedrigerer als auch höherer Frequenz ein Zeitintegral mit dem Wert Null ergeben.

Bei der in Figur 9 dargestellten Schaltung gelangt das Eingangssignal DIAN zu drei parallelen Signalverarbeitungsbaugruppen, welche in der Zeichnung mit SZ1, SZ2 und SZ3 gekennzeichnet sind. Jede der Baugruppen SZ1 bis SZ3 weist je einen Inverter 101 bis 103 auf und jeweils zwei steuerbare Schalter für das Eingangssignal 104, 105; 106, 107 und 108, 109 auf, von denen jeweils einer 104, 106, 108 direkt mit dem Eingangssignal und der andere 105, 107, 109 über jeweils einen Inverter mit dem Eingangssignal DIAN verbunden ist. Die Ausgänge der Schalter 104 bis 109 sind zusammengeführt und für jeden der Verarbeitungskanäle SZ1 bis SZ3 mit einem Integrator 110, 111 bzw. 112 verbunden. Dem Integrator ist wiederum jeweils ein Analog-Digitalwandler 113, 114 und 115 nachgeschaltet.

Den Analog-Digitalwandlern sind jeweils Latches als Zwischenspeicher 116, 117, 118 und 119 nachgeschaltet, welche das digitalisierte Signal kurzfristig festhalten, wobei im Verarbeitungsweg SZ2, 3 zwei abwechselnd aktivierte Zwischenspeicher vorgesehen sind. Die binären Ausgangssignale der Zwischenspeicher 116 bis 119 sind mit dem Paralleleingängen eines Parallel-Seriell-Wandlers 120 verbunden, der das rückgewandelte Signal an eine Ausgangsseite 121 übermittelt.

Die Decodierung beruht nun auf einer mit der Polarität des jeweils auszuwertenden Teilschwingungszugs am Eingang (DIAN-Signal) synchronen Steuerung der Schalter 104 bis 109. Die Schalter für den Schwingungszug SZ1 mit der niedrigsten Frequenz werden in Abhängigkeit von der Polarität des Eingangssignals gesteuert. Eine Polaritätserkennungsschaltung 122 aktiviert dabei jeweils im Takt der Halbwellen des Eingangssignals die Umschalter 104 und 105, so daß am Ausgang des Integrators 110 der gleichgerichtete Schwingungszug gemittelt - und damit dessen Amplitude - ansteht. Die Polaritätserkennungsschaltung 122 weist einen gewissen "Schwungradeffekt" auf, ist also von höherfrequenten Anteilen des DIAN-Signals unabhängig. Ein derartiger "Schwungradeffekt" wird beispielsweise durch eine sogenannte PLL-Schaltung verwirklicht.

Die weiteren Schalter 106 bis 109 werden im Takt der Halbwellen der Schwingungszüge SZ2 bzw. SZ3 aktiviert, wobei die Steuersignale für diese Schalter von einem Taktgenerator 123 abgegeben werden. Dieser Taktgenerator wird von einem spannungsabhängigen Oszillator (VCO) 124 angesteuert, der seinerseits mit der Polaritätserkennungsschaltung 122 synchronisiert ist, so daß die Steuersignale für die Schalter 106 bis 109 vom Taktgenerator 123 zeitlich den Halbwellen der Teilschwingungszüge SZ2 (Schalter 106 und 107) bzw. SZ3 (Schalter 108 und 109) entsprechen. Der Taktgenerator 123 arbeitet synchron mit der Polaritätserkennungsschaltung 122. Dabei schwingt der VCO 124 mit einem Vielfachen der Teilschwingungszugs SZ1.

Dazu wird das mit der vom Taktgenerator 124 den Halbwellen des Teilschwingungszugs SZ1 entsprechend getaktete (Schalter 125) DIAN-Eingangssignal mit dem entsprechenden, direkt über die Polaritätserkennungsschaltung 122 abgeleiteten Signal verglichen, welches von dem Schalter 126 ausgegeben wird. Um dieses Signal vom Ausgangsignal des Schalters 106 zu entkoppeln, ist ein weiterer, synchron mit dem Schalter 107 aktivierter Schalter 127 vorgesehen, der das DIAN-Signal in Abhängigkeit von der Polaritätserkennungsschaltung 122 weiterleitet. Die Ausgangssignale des Schalters 125 und des Schalters 127 werden daher in einer Additionsschaltung 126 summiert und anschließend in einer Integratorschaltung 128 integriert. Am Ausgang des Integrators 128 ergibt sich somit bei einer Asynchronität (Frequenzabweichung) zwischen dem Vielfachen der Schaltfreuenz der Polaritätserkennungsschaltung und dem VCO ein Abweichungssignal, dessen Polarität der Richtung der Abweichung entspricht.

Das Abweichungssignal als Ausgangssignal des Integrators 127 wird dem spannungsabhängigen Oszillator (VCO) 124 als Eingangssignal zugeführt, welcher seinerseits in Abhängigkeit von der Ausgangsspannung des Integrators 127 ein von der Frequenz abhängiges Taktsignal an den Taktgeber 123 abgibt. Auf diese Weise erfolgt die Decodierung der in den Teilschwingungszügen SZ1 bis SZ3 enthaltenen Signalanteile synchronisiert zu den Schwingungsanteilen des DIAN-Eingangssignals.

Die Zwischenspeicher 116 bis 119 werden ebenfalls vom Taktgeber 123 in geeigneter Zeitfolge gesteuert. Sie nehmen die jeweils letzten durch Dekodierung erhaltenen Signalanteile auf und speichern sie, bis an ihren Eingängen eine Änderung eintritt.

Dabei enthält der Schwingungszug SZ1 vier Bit - und zwar in jeder Halbwelle zwei. Der Schwingungszug SZ2 enthält in jeder Vollwelle eine Digitalinformation von drei Bit, wobei jede Vollwelle des Schwingungszuges SZ2 einer Halbwelle des Schwingungzuges SZ1 entspricht. Der Schwingungszug SZ3 enthält in jeder Vollwelle zwei Bit. Da die Frequenz doppelt so hoch ist wie die des Schwingungszuges SZ2 fallen die Signale SZ3 pro Halbwelle von SZ1 zweimal an, so daß die beiden Zwischenspeicher 118 und 119 abwechselnd pro Halbwelle von SZ1 mit einer neuen Information geladen werden.

Innerhalb einer Halbwelle von SZ1 wird also der Parallel-Seriell-Wandler 121 jeweils einmal durch ein geeignetes, nicht dargestelltes, vom Taktgenerator 123 erhaltenes Strobe-Signal komplett mit dem Informationsinhalt eines Signalzugs parallel aufgefüllt, um anschließend im Zeitraum vor dem nächsten Strobe-Signal seriell ausgelesen zu werden.

Inzwischen werden die Zwischenspeicher 116 bis 119 wieder mit Information gefüllt, die dann zum anschließenden seriellen Auslesen wieder in den Parallel-Seriell-Wandler 121 übertragen wird.

Die Erfindung beschränkt sich in ihrer Ausführung nicht auf das vorstehend angegebene bevorzugte Ausführungsbeispiel. Vielmehr ist eine Anzahl von Varianten denkbar, welche von der dargestellten Lösung auch bei grundsätzlich anders gearteten Ausführungen Gebrauch machen.

**Patentansprüche**

1. Verfahren zur analogen Übertragung oder Speicherung einer digitalen Information, **dadurch gekennzeichnet,** daß die digitale Information einem durch die summierende, in fester Phasenzuordnung vorgenommene. Überlagerung mehrerer schmalbandiger Teilschwingungszüge (SZ$_1$ bis SZ$_3$) gebildeten Gesamtschwingungszug (DIAN-Signal) aufgeprägt wird, wobei die digitalen Information in jeweils mehrere Datenbits enthaltende Teilinformationen zerlegt wird und die Amplitude jedes Teilschwingungszugs (SZ$_1$ bis SZ$_3$) in Abhängigkeit von den mehreren Datenbits der Teilinformation derart bemessen wird, daß sie einer Amplitudenstufe eines eine Anzahl von diskreten Amplitudenstufen enthaltenden Wertevorrats entspricht.

2. Verfahren nach Anspruch 1, **dadurch gekennzeichnet,** daß der Teilschwingungszug Sinus- oder sinusähnliche Form aufweist, wobei die Amplitudenwerte die Sinusamplituden bilden.

3. Verfahren nach Anspruch 2, **dadurch gekennzeichnet,** daß ein Amplitudenwert die Amplitude einer Halbwelle oder die Amplituden zweier Halbwellen einer Vollwelle bildet.

4. Verfahren nach Anspruch 3, **dadurch gekennzeichnet,** daß bei dem Teilschwingungszug mit der niedrigsten Frequenz (SZ$_1$) der Amplitudenwert die Amplitude einer Halbwelle bildet, während bei den Teilschwingungszügen mit höheren Frequenzen (SZ$_2$, SZ$_3$) der Amplitudenwert zwei aufeinanderfolgende Halbwellen einer Vollwelle bildet.

5. Verfahren nach einem der vorangehenden Ansprüche, **dadurch gekennzeichnet,** daß Frequenzen der Teilschwingungszüge (SZ$_1$ bis SZ$_3$) sich voneinander um ganzzahlige Vielfache unterscheiden.

6. Verfahren nach Anspruch 5, **dadurch gekennzeichnet,** daß sich die Frequenzen der Teilschwingungszüge ($SZ_1$ bis $SZ_3$) jeweils um den Faktor zwei unterscheiden.

7. Verfahren nach einem der Ansprüche 5 oder 6, **dadurch gekennzeichnet,** daß Nulldurchgänge der Teilschwingungszüge höherer Frequenz ($SZ_2$, $SZ_3$) mit den Nulldurchgängen von Teilschwingungszügen niedrigerer Frequenz ($SZ_1$, $SZ_2$) zusammenfallen.

8. Verfahren nach einem der vorangehenden Ansprüche, **dadurch gekennzeichnet,** daß die Amplitude des Teilschwingungszugs mit der niedrigsten Frequenz ($SZ_1$) einen vorgegebenen Wert nicht unterschreitet, wobei der vorgegebene Wert den durch die Teilinformation bestimmten Amplitudenstufen additiv überlagert ist.

9. Verfahren nach einem der vorangehenden Ansprüche, **dadurch gekennzeichnet,** daß die Teilinformationen jeweils den Teilschwingungszügen ($SZ_1$ bis $SZ_3$) eines Übertragungsintervalls aufgeprägt werden, dessen Dauer der Halb- oder Grundwellendauer des Teilschwingungszuges mit der niedrigsten Frequenz ($SZ_1$) entspricht.

10. Verfahren nach einem der vorangehenden Ansprüche, **gekennzeichnet durch** eine Frequenzfilterung des Gesamtschwingungszuges (DIAN-Signal) mit einer oberen Grenzfrequenz, die im wesentlichen der doppelten Frequenz des in dem Gesamtschwingungszug enthaltenen Teilschwingungszuges mit der höchsten Frequenz ($SZ_3$) entspricht.

11. Verfahren nach einem der vorangehenden Ansprüche, **dadurch gekennzeichnet,** daß der Gesamtschwingungszug (DIAN-Signal) einem Trägersignal aufmoduliert wird.

12. Verfahren nach Anspruch 11, **dadurch gekennzeichnet,** daß es sich bei der Modulation um Frequenz-, Phasen- oder Amplitudenmodulation handelt.

13. Verfahren nach einem der vorangehenden Ansprüche, **dadurch gekennzeichnet,** daß zur Wiedergewinnung der digitalen Information eine Abtastung des Gesamtschwingungszuges (DIAN-Signal) in einem vorgegebenen Zeitraster erfolgt und aus den ermittelten Momentanamplituden die den Teilinformationen entsprechenden Amplitudenwerte der Teilschwingungszüge ($SZ_1$ bis $SZ_3$) zurückgewonnen werden.

14. Verfahren nach Anspruch 13, **dadurch gekennzeichnet,** daß die Momentanamplituden innerhalb einer Periodendauer des Teilschwingungszuges mit der niedrigsten Frequenz ($SZ_1$) unter Berücksichtigung des Amplitudenverlaufs der jeweils anderen Teilschwingungszüge ($SZ_2$, $SZ_3$) ermittelt werden.

15. Verfahren nach Anspruch 14, **dadurch gekennzeichnet,** daß die Abtastung jeweils während des Nulldurchgangs mindestens eines der überlagerten Teilschwingungszüge ($SZ_1$ bis $SZ_3$), oder durch Integration des im Takte des jeweils zu decodierenden Teilschwingungszugs gleichgerichteten Gesamtschwingungszugs (DIAN-Signal) erfolgt.

16. Verfahren nach den Ansprüchen 7 und 15, **dadurch gekennzeichnet,** daß der Amplitudenwert eines ersten Teilschwingungszugs mit der niedrigsten Frequenz ($SZ_1$) durch Abtastung bzw. Auswertung der integrierten Abtastwerte zu einem Zeitpunkt bzw. während eines Zeitbereichs erfolgt, für den alle anderen Teilschwingungszüge mit höherer Frequenz ($SZ_2$, $SZ_3$) ihren Nulldurchgang aufweisen bzw. zu Null werden, wohingegen die Abtastung bzw. Auswertung der anderen Schwingungszüge ($SZ_2$, $SZ_3$) zu Zeitpunkten bzw. in Zeitbereichen folgt, für die mindestens ein anderer Schwingungszug ($SZ_1$, $SZ_2$) mit einer anderen Frequenz einen Nulldurchgang aufweist bzw. zu Null wird.

17. Verfahren nach Anspruch 16, **dadurch gekennzeichnet,** daß die Abtastung bzw. Auswertung jeweils zum Zeitpunkt ($t_1$ bis $t_4$) 3/8, 1/2, 3/4 und 7/8 der Dauer einer Halbwelle des Teilschwingungszugs mit der niedrigsten Frequenz ($SZ_1$) erfolgt.

18. Schaltung zur analogen Übertragung oder Speicherung einer digitalen Information, **dadurch gekennzeichnet,** daß eine senderseitige Codierschaltung aufweist: Mittel (13 bis 16) zur Amplitudenbeeinflussung von Schwingungszügen begrenzter Frequenz ($SZ_1$ bis $SZ_3$) in diskreten Stufen, Mittel (4,5) zur Zerlegung der digitalen Information in aus mehreren Datenbits bestehende Teilinformationen, Mittel (6 bis 8), zur Zuordnung eines Amplituden- bzw. Phasenwert eines Schwingungszuges zu jeder Teilinformation und Mittel (21) zur linearen Überlagerung der einzelnen Schwingungszüge und eine empfängerseitige Decodierschaltung (80 bis 82) invers dazu ausgebildet ist und Schwellwertdiskriminatoren zur Rückwandlung der Amplituden- bzw. Phasenwerte in die digitalen Teilinformationen aufweist.

19. Schaltung nach Anspruch 18, **dadurch gekennzeichnet,** daß Quantisierungsstufen (6 bis 8) vorgesehen sind, denen als Eingangssignale die Teilinformationen zugeführt werden und deren Ausgänge mit einer Summierschaltung (21) zur linearen Überlagerung der Schwingungszüge verbunden sind.

20. Schaltung nach Anspruch 19, **dadurch gekennzeichnet,** daß der Summierschaltung (21) ein Frequenzmodulator (26) nachgeschaltet ist.

21. Schaltung nach einem der Ansprüche 18 bis 20, **dadurch gekennzeichnet,** daß die empfängerseitige Decodierschaltung (80 bis 82) eine Schaltung (73, 83 bis 86) zur, insbesondere phasengesteuerten, Synchronisation der Bezugszeitpunkte für die Ermittlung der Amplitudenwerte der Teilschwingungszüge aufweist.

22. Schaltung nach Anspruch 21, **gekennzeichnet durch** eine Schaltung zur Veränderung des Amplitudenwerts eines Teilschwingungszugs und/oder dessen Phasenlage relativ zu anderen Teilsschwingungszügen in Abhängigkeit von mindestens einem für einen anderen Teilschwingungszug ermittelten Amplitudenwert und/oder dessen Phasenlage relativ zu mindestens einem anderen Teilschwingungszug.

## Claims

1. A method of analog transmission or storage of digital information, characterised in that the digital information is impressed on a complete cycle (DIAN signal) formed by the summing superimposition of a plurality of narrow band part cycles (SZ1 to SZ3) effected in a fixed phase relation, that the digital information is divided into information components each containing a plurality of data bits, and that the amplitude of each part cycle (SZ1 to SZ3) is measured dependent on the plurality of data bits of the information component, in such a way that it corresponds to an amplitude stage of a stock of values containing a number of discrete amplitude stages.

2. A method according to claim 1, characterised in that the part cycle has a sine or sine like shape, with the amplitude values forming the sine amplitudes.

3. A method according to claim 2, characterised in that an amplitude value forms the amplitude of a half wave or the amplitudes of two half waves of a complete wave.

4. A method according to claim 3, characterised in that in the case of the part cycle with the lowest frequency (SZ1) the amplitude value forms the amplitude of a half wave, whereas in the case of the part cycles with higher frequencies (SZ2, SZ3) the amplitude value forms two successive half waves of a complete wave.

5. A method according to any of the preceding claims characterised in that frequencies of the part cycles (SZ1 to SZ3) differ from one another by integral multiples.

6. A method according to claim 5, characterised in that the frequencies of the part cycles (SZ1 to SZ3) differ by a factor of 2 in each case.

7. A method according to claim 5 or 6, characterised in that zero transitions of the higher frequency part cycles (SZ2, SZ3) coincide with the zero transitions of lower frequency part cycles (SZ1, SZ2).

8. A method according to any of the preceding claims, characterised in that the amplitude of the lowest frequency part cycle (SZ1) does not drop below a predetermined value, and that the predetermined value is superimposed additively on the amplitude stages determined by the information component.

9. A method according to any of the preceding claims, characterised in that the information components are each impressed on the part cycles (SZ1 to SZ3) of a transmission interval, the duration of which corresponds to the half wave or basic wave duration of the lowest frequency part cycle (SZ1).

10. A method according to any of the preceding claims, characterised by frequency filtering of the complete cycle (DIAN signal) with an upper cut off frequency substantially corresponding to twice the frequency of the highest frequency part cycle (SZ3) contained in the complete cycle.

11. A method according to any of the preceding claims, characterised in that the complete cycle (DIAN signal) is modulated onto a carrying signal.

**12.** A method according to claim 11, characterised in that the modulation takes the form of frequency, phase of amplitude modulation.

**13.** A method according to any of the preceding claims, characterised in that as a means of recovering the digital information the complete cycle (DIAN signal) is sampled in a predetermined time sequence, and the amplitude values of the part cycles (SZ1 to SZ3) corresponding to the information components are recovered from the instantaneous amplitudes determined.

**14.** A method according to claim 13, characterised in that the instantaneous amplitudes within a period duration of the lowest frequency part cycle (SZ1) are determined taking into account the course of the amplitude of the other part cycles (SZ2, SZ3).

**15.** A method according to claim 14, characterised in that sampling takes place in each case during the zero transition of at least one of the superimposed part cycles (SZ1 to SZ3) or by integration of the complete cycle (DIAN signal) rectified synchronously with the particular part cycle to be decoded.

**16.** A method according to claims 7 and 15, characterised in that the amplitude value of a first part circuit with the lowest frequency (SZ1) is obtained by sampling and/or evaluation of the integrated sampling values at a time or during a time range for which all other part cycles at higher frequencies (SZ2, SZ3) have their zero transition or become zero, whereas the sampling or evaluation of the other cycles (SZ2, SZ3) follows at times or within time ranges for which at least one other cycle (SZ1, SZ2) with a different frequency has a zero transition or becomes zero.

**17.** A method according to claim 16, characterised in that sampling and/or evaluation in each case take place at the time (t1 to t4) of 3/8, $\frac{1}{2}$, 3/4 and 7/8 of the duration of a half wave of the lowest frequency part cycle (SZ1).

**18.** A circuit for analog transmission or storage of digital information, characterised in that a coding circuit at the transmitter has: means 13 to 16 for influencing the amplitude of cycles of limited frequency (SZ1 to SZ3) in discrete stages, means (4,5) for dividing the digital information into information components comprising a plurality of data bits, means (6 to 8) for assigning an amplitude or phase value of a cycle to each information component and means (21) for linear superimposition of the individual cycles, and that a decoding circuit (80 to 82) at the receiver is of the inverse construction and has threshold value discriminators for converting the amplitude or phase values back to the digital information components.

**19.** A circuit according to claim 18, characterised in that quantising stages (6 to 8) are provided, to which the information components are supplied as input signals, and the outputs of which are connected to a summing circuit (21) for linear superimposition of the cycles.

**20.** A circuit according to claim 19, characterised in that the summing circuit (21) is followed by a frequency modulator (26).

**21.** A circuit according to claims 18 to 20, characterised in that the decoding circuit (80 to 82) at the receiver has a circuit (73, 83 to 86) for synchronisation, particularly phase controlled synchronisation of the reference times for determining the amplitude values of the part cycles.

**22.** A circuit according to claim 21, characterised by a circuit for changing the amplitude value of a part cycle and/or its phase position relative to other part cycles dependent on at least one amplitude value, determined for a different part cycle, and/or its phase position relative to at least one other part cycle.

**Revendications**

**1.** Procédé pour la transmission ou la mise en mémoire analogiques d'une information numérique,
caractérisé en ce que l'information numérique est impartie à un train d'oscillations total (signal-DIAN) formé par la superposition de plusieurs trains d'oscillations partiels (SZ1 à SZ3) à bande étroite, entreprise en coordination de phases fixe, par sommation, l'information numérique étant fractionnée en des informations partielles contenant chaque fois plusieurs bits de données, et l'amplitude de chaque train d'oscillations partiel (SZ1 à SZ3), en fonction des bits de données multiples de l'information partielle, étant dimensionnée de telle sorte, qu'elle correspond à un degré d'amplitude d'une réserve de valeurs contenant un certain nombre de degrés d'amplitude discret.

2.  Procédé selon la revendication 1, caractérisé en ce que le train d'oscillations partiel présente une forme sinusoïdale ou semblable à une forme sinusoïdale, les valeurs d'amplitude formant les amplitudes sinusoïdales.

3.  Procédé selon la revendication 2, caractérisé en ce qu'une valeur d'amplitude forme l'amplitude d'une demi-onde ou les amplitudes de deux demi-ondes d'une onde complète.

4.  Procédé selon la revendication 3, caractérisé en ce que, lors du train d'oscillations partiel avec la fréquence la plus basse (SZ1), la valeur d'amplitude forme l'amplitude d'une demi-onde, tandis que lors des trains d'oscillations partiels avec des fréquences plus élevées (SZ2, SZ3), la valeur d'amplitude forme deux demi-ondes, se suivant l'une l'autre, d'une onde complète.

5.  Procédé selon une des revendications précédentes, caractérisé en ce que les fréquences des trains d'oscillations partiels (SZ1 à SZ3) se différencient les unes des autres par un multiple entier.

6.  Procédé selon la revendication 5, caractérisé en ce que les fréquences des trains d'oscillations partiels (SZ1 à SZ3), chaque fois, se différencient par le facteur deux.

7.  Procédé selon une des revendications 5 ou 6, caractérisé en ce que des passages par zéro des trains d'oscillations partiels de fréquence plus élevée (SZ2, SZ3) coïncident avec les passages par zéro de trains d'oscillations partiels de fréquence plus basse (SZ2, SZ2).

8.  Procédé selon une des revendications précédentes, caractérisé en ce que l'amplitude du train d'oscillation partiel avec la fréquence la plus basse (SZ1) ne passe pas au-dessous d'une valeur préallouée, la valeur préallouée étant superposée de façon additive aux degrés d'amplitude déterminés par l'information partielle.

9.  Procédé selon une des revendications précédentes, caractérisé en ce que les informations partielles sont imparties, chaque fois, aux trains d'oscillations partiels (SZ1 à SZ3) d'un intervalle de transmission, dont la durée correspond à la durée de la demi-onde ou à la durée de l'onde fondamentale du train d'oscillations partiel avec la fréquence la plus basse (SZ1).

10. Procédé selon une des revendications précédentes, caractérisé par un filtrage de fréquence du train d'oscillations entier (signal-DIAN) avec une fréquence limite supérieure, qui, pour l'essentiel, correspond au double de la fréquence du train d'oscillations partiel avec la fréquence la plus élevée (SZ3) contenu dans le train d'oscillations entier.

11. Procédé selon une des revendications précédentes, caractérisé en ce que le train d'oscillations entier (signal-DIAN) est modulé sur un signal porteur.

12. Procédé selon la revendication 11, caractérisé en ce qu'il s'agit lors de la modulation d'une modulation de fréquence, de phase, ou d'amplitude.

13. Procédé selon une des revendications précédentes, caractérisé en ce que pour la récupération de l'information numérique, une exploration du train d'oscillations entier (signal-DIAN) a lieu dans une trame de temps préallouée, et, à partir des amplitudes instantanées détectées, les valeurs d'amplitude des trains d'oscillations partiels (SZ1 à SZ3) correspondant aux informations partielles, sont recouvrées.

14. Procédé selon la revendication 13, caractérisé en ce que les amplitudes instantanées à l'intérieur d'une durée de période du train d'oscillations partiel avec la fréquence la plus base (SZ1) sont déterminées en prenant en considération, chaque fois, l'allure d'amplitude des autres trains d'oscillations partiels (SZ2, SZ3).

15. Procédé selon la revendication 14, caractérisé en ce que l'exploration a lieu, chaque fois, pendant le passage par zéro d'au moins un des trains d'oscillations partiels (SZ1 à SZ3) superposés, ou par intégration du train d'oscillations entier (signal-DIAN) redressé en synchronisation, chaque fois, avec le train d'oscillations partiel à décoder.

16. Procédé selon les revendications 7 et 15, caractérisé en ce que la valeur d'amplitude d'un premier train d'oscillations partiel avec la fréquence la plus basse (SZ1) résulte de l'exploration ou bien de l'évaluation des valeurs d'exploration intégrées à un instant ou bien pendant une plage de temps, pour lesquels, tous les autres trains d'oscillations partiels avec fréquence plus élevée (SZ2, SZ3) présentent leur passage par zéro ou bien sont nuls, par contre, l'exploration ou bien l'évaluation des autres trains d'oscillations (SZ2, SZ3) ont lieu à des instants ou bien dans des plages de temps, pour lesquels, au moins un autre train d'oscillations (SZ1, SZ2) avec une autre fréquence présente un passage par zéro ou bien est nul.

17. Procédé selon la revendication 16, caractérisé en ce que l'exploration ou bien l'évaluation ont lieu, chaque fois, à l'instant (t1 à t4) de 3/8, 1/2, 3/4 et 7/8 de la durée d'une demi-onde du train d'oscillations partiel avec la fréquence la plus basse (SZ1).

18. Circuit pour la transmission ou la mise en mémoire analogiques d'une information numérique, caractérisé en ce qu'un circuit de codage côté émetteur présente : des moyens (13 à 16) pour influer sur l'amplitude de trains d'oscillations de fréquence limitée (SZ1 à SZ3) en degrés discrets, des moyens (4,5) pour le fractionnement de l'information numérique en plusieurs informations partielles consistant en plusieurs bits de données, des moyens (6 à 8) pour l'adjonction de chaque information partielle à une valeur d'amplitude ou bien une valeur de phase d'un train d'oscillations et des moyens (21) pour la superposition linéaire des trains d'oscillations individuels, et un circuit de décodage (80 à 82) côté récepteur est constitué inverse à celui-ci et présente des discriminateurs de valeur de seuil, pour la transformation en retour des valeurs d'amplitude ou bien des phases dans les informations partielles numériques.

19. Circuit selon la revendication 18, caractérisé en ce que des étages de quantification (6 à 8) sont prévus, auxquels les informations partielles sont conduites comme des signaux d'entrée et dont les sorties sont reliées avec un circuit de sommation (21) pour la superposition linéaire des trains d'oscillations.

20. Circuit selon la revendication 19, caractérisé en ce qu'un modulateur de fréquence (26) est mis en circuit en aval du circuit de sommation (21).

21. Circuit selon une des revendications 18 à 20, caractérisé en ce que le circuit de décodage côté récepteur (80 à 82) présente un circuit (73, 83 à 86) pour la synchronisation, en particulier commandée en phase, des instants de référence pour la détection des valeurs d'amplitude des trains d'oscillations partiels.

22. Circuit selon la revendication 21, caractérisé par un circuit pour le changement de la valeur d'amplitude d'un train d'oscillations partiel et/ou de l'état de phase de celui-ci relativement à d'autres trains d'oscillations partiels, en fonction d'au moins une valeur d'amplitude détectée pour un autre train d'oscillations partiel et/ou l'état de phase de celui-ci relativement à au moins un autre train d'oscillations partiel.

Fig. 1

Fig. 1a

Konventionelles
Datensignal

Bitfolge

Zeit

O | O | | O O | O | | O | | | O | O O | O | | O

SZ1    SZ2

Übertragungsintervall

Quantelstufe

EP 0 474 710 B1

Fig. 2

Fig. 3

Fig.4

Fig.4a-k

Fig. 5

Abtastpunkte

Signal $t_1$ $t_2$ $t_3$ $t_4$ $t_5$

t

Auslesespeicher

| 1 | 2 | 3 | 4 | 5 | 6 | 7 | 8 | Bitposition |

Fig. 6

Fig. 7

Übertragungsspektren

Fig. 8

Fig. 9